# EUROPÄISCHE PATENTANMELDUNG

(11) **EP 2 040 528 A1**
(43) Veröffentlichungstag der Anmeldung: **25.03.2009**
(21) Anmeldenummer: 08104959.5
(22) Anmeldetag: 05.08.2008
(51) Int. Cl.: H05K 7/14, H05K 3/36

(54) **Modul für eine integrierte Steuerelektronik mit vereinfachtem Aufbau**

(30) Priorität: 18.09.2007 DE 102007044394
(71) Anmelder: Continental Automotive GmbH, 30165 Hannover (DE)
(72) Erfinder: Loibl, Josef, 93077, Bad Abbach (DE); Preuschl, Thomas, 93161, Eilsbrunn (DE); Schingale, Angelika, 93059, Regensburg (DE); Smirra, Karl, 83512, Wasserburg (DE)

(57) **Zusammenfassung**

Die Erfindung betrifft ein Gehäusekonzept (1) für eine integrierte Steuerungselektronik mit einem Gehäuseboden (2), einer zentralen Steuerungselektronik (12) mit elektronischen Bauteilen, einem Verbindungsträger (4) und einer Signal- und Stromverteilungskomponente (5) als elektrischer Verbindung zwischen der zentralen Steuerungselektronik (12) und peripheren Komponenten, wobei der Gehäuseboden (2) wannenförmig ausgestaltet ist, darin der Verbindungsträger (4) mit Kontaktstiften (6) und die zentrale Steuerungselektronik (12) derart angeordnet sind, dass die Steuerungselektronik (12) durch die Kontaktstifte (6) elektrisch mit der darüber angeordneten Signal- und Stromverteilungskomponente (5) verbunden werden kann, und wobei der Gehäuseboden (2) umlaufend mit der Signal- und Stromverteilungskomponente (5) verbunden ist.

## Beschreibung

Die Erfindung betrifft ein Modul für eine integrierte Steuerelektronik gemäß dem Oberbegriff des Patentanspruchs 1 sowie dessen Verwendung, insbesondere für Getriebe- oder Motorsteuerungen in der Automobilindustrie.

### Stand der Technik

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu integrierten mechatronischen Steuerungen, also zur Integration von Steuerelektronik und den zugehörigen elektronischen Komponenten wie Sensoren oder Ventile in das Getriebe, den Motor oder das Bremssystem. Steuergeräte weisen also im Allgemeinen eine Vielzahl an elektronischen Komponenten auf, welche in Verbindung mit anderen Komponenten außerhalb des Steuergerätes stehen. Bei solchen "Vorort-Elektroniken" sind diese Steuerungen nicht mehr in einem separaten geschützten Elektronikraum untergebracht und müssen daher entsprechenden Umwelteinflüssen und mechanischen, thermischen sowie chemischen Beanspruchungen standhalten.
Sie werden zu diesem Zweck normalerweise in spezielle Gehäuse eingesetzt. Zudem erfüllen die Gehäuse eine wichtige Abschirmfunktion. Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

Der übliche Aufbau für solche integrierten mechatronischen Anwendungen besteht aus einem keramischen Substrat, das die verschiedenen elektronischen Bauteile der zentralen Steuerungseinheit beinhaltet. Dieses komplexe keramische Substrat wird mittels Bonden mit starren oder flexiblen Leiterplatten verbunden, um die Anbindung der peripheren Komponenten an die Zentraleinheit zu ermöglichen. Wie schon beschrieben sind zum Beispiel Getriebesteuerungsmodule im Getriebeölsumpf untergebracht und daher vollständig mit Öl und der darin enthaltenen leitenden Kontamination umgeben. Dies können zum Beispiel Kontaminationen aus Verzahnungsabrieb, Zerspanungsreste aus Fertigungsprozessen oder unzulänglichen Wasch- und Reinigungsprozessen des Getriebegehäuses und/oder der verbauten Komponenten sein. Zum notwendigen Schutz vor solcher Kontamination, vor Beschädigungen und Leiterbahn- oder Bondkurzschlüssen wird eine Verdeckelung, üblicherweise als metallischer, nicht-metallischer oder metallisierter Gehäusedeckel, auf die Gehäusebodenplatte aufgebracht und hermetisch abgedichtet. Dieser Gesamtverbund aus keramischem Substrat, Leiterplatten und deren Anbindung zur elektronischen Verbindung der Peripherie sowie hermetisch dichtem Gehäuse ist ein signifikanter Kostentreiber. Gerade die bevorzugt als Schaltungsträger eingesetzten LTCCs (Low Temperature co-fired Ceramics), die zur mechanischen Stabilität und thermischen Anbindung auf eine Grundplatte aufgebracht werden, stellen einen großen Kostenfaktor des gesamten Bauteils dar. Ihre elektronische Verbindung über flexible Leiterplatten oder Stanzgitter zu den außerhalb des abgedichteten Gehäuses liegenden Komponenten ist zudem aufwendig und daher kostenträchtig.

### Aufgabenstellung

Aufgabe der Erfindung ist es daher, ein Modul für eine integrierte Steuerelektronik mit einem Gehäuse, einer darin untergebrachten zentralen Steuerungseinheit umfassend verschiedene elektronische Bauteile und einer elektronischen Verbindung zwischen dem Gehäuseinnenraum und dem Gehäuseaußenraum bereit zu stellen, welche eine einfache und flexible Verbindung zu außerhalb des Gehäuses liegenden Komponenten ermöglicht, wobei die elektronische Verbindung zwischen der zentralen Steuerungseinheit und der Signal- und Stromverteilungskomponente einen vereinfachten und daher kostengünstigeren Aufbau aufweisen soll, mit günstigen Materialien zu realisieren sein soll und gleichzeitig sicher vor Kurzschluss und/oder leitender Kontamination schützen soll.

Dies wird erfindungsgemäß mit einer Vorrichtung entsprechend des Patentanspruchs 1 erreicht.

Erfindungsgemäß wird ein Gehäusekonzept für eine integrierte Steuerungselektronik mit einem Gehäuseboden, einem Verbindungsträger, einer zentralen Steuerungselektronik mit elektronischen Bauteilen und einer Signal- und Stromverteilungskomponente als elektrischer Verbindung zwischen der zentralen Steuerungselektronik und peripheren Komponenten vorgeschlagen, bei dem der Gehäuseboden wannenförmig ausgestaltet ist, darin der Verbindungsträger mit Kontaktstiften und die zentralen Steuerungselektronik derart angeordnet sind, dass die Steuerungselektronik durch die Kontaktstifte elektrisch mit der darüber angeordneten Signal- und Stromverteilungskomponente verbunden werden kann, und dass der Gehäuseboden umlaufend mit der Signal- und Stromverteilungskomponente verbunden ist.

Mit anderen Worten wird erfindungsgemäß ein beispielsweise kranzförmiger Rahmenaufbau mit elektrischen Anschlüssen als Verbindungsträger eingesetzt, der Kontakt herstellt zwischen den elektronischen Bauteilen der zentralen Steuerungseinheit und der Signal- und Stromverteilungskomponente. Die Ableitung der durch die Leistungseinheiten der zentralen Steuerelektronik erzeugten Wärme wird über den wannenförmig ausgestalteten Gehäuseboden sichergestellt. Der Einsatz teurer flexibler Leiterplatten für die Anbindung der zentralen Steuereinheit an die peripheren Komponenten ist damit nicht mehr notwendig, die Funktion kann jedoch mit dem erfindungsgemäßen Gehäusekonzept dennoch kostengünstig und vereinfacht vorgenommen werden. Durch das erfindungsgemäße Konzept kann vorteilhaft die Außenkontur des elektronischen Bauteils durch einen Stanzprozess variabel an die applikationsspezifischen Vorgaben angepasst werden. Hinsichtlich der Signal- und Stromverteilungskomponente kann neben der Realisierung von Kreuzungen und sehr feiner Leiterbahnstrukturen auch eine flächenoptimierte Struktur mit einer hohen Anzahl von Anschlusskontakten bereitgestellt werden. Der Verbindungsträger kann zusätzlich zur mechanischen Stabilität des gesamten Moduls beitragen und kann bevorzugt aus kostengünstigen Materialien gefertigt sein.

Es können als Signal- und Stromverteilungskomponenten erfindungsgemäß beispielsweise vergleichsweise kostengünstige PCB-Leiterplatten (Printed Circuit Bords) eingesetzt werden. Gleichermaßen ist es möglich, wenn auch nicht bevorzugt, als Signal- und Stromverteilungskomponente mehrlagige flexible Leiterplatten einzusetzen. Die Signal- und Stromverteilungskomponente ist bevorzugt zwei- oder mehrlagig. So kann bevorzugt eine zweilagige PCB-Leiterplatte mit einem elektrisch isolierenden Kern und einer Kupferbeschichtung eingesetzt werden.

Besonders bevorzugt wird eine doppelseitige PCB zur Signal- und Stromverteilung an periphere Komponenten wie beispielsweise Stecker, Sensoren oder Aktuatoren eingesetzt, die aus einem elektrisch isolierenden Kern und einer beidseitig aufgebrachten leitenden Beschichtung, bevorzugt aus Kupfer, aufgebaut ist. Zur Vermeidung von Kurzschlüssen können offene Leiterbahnbereiche durch einen Lötstopplack abgedeckt werden. Dieser Aufbau ist relativ dünn und ermöglicht vorteilhafterweise die Ausbildung von dreidimensionalen Strukturen durch Biegen einzelner PCB-Bereiche. Dies ist für einen Einsatz beispielsweise in einem Getriebe sehr hilfreich, da unter anderem verschiedene Kontaktierlevel erforderlich sind. Gleichzeitig sind im Gegensatz zu einlagigen flexiblen Leiterplatten zudem Kreuzungen der Verteilungspfade möglich.

Weiterhin bevorzugt weist die mehrlagige Signal- und Stromverteilungskomponente ihrerseits verschiedene Kontaktstellen zur elektronischen Anbindung der peripheren Komponenten auf. Wie vorstehend bereits beschrieben können sowohl Anschlüsse für Stecker als auch für Sensoren, Ventile und andere Aktuatoren vorgesehen werden, was eine große Flexibilität des Gesamtaufbaus des elektronischen Bauteils ermöglicht.

In einer bevorzugten Ausgestaltung kann die elektronische Anbindung der außerhalb des Gehäuses liegenden Komponenten mittels Einpresstechnik, Löten, Kleben und/oder Laserschweißen ausgeführt werden.
Generell ist die Art der Verbindungsherstellung nicht kritisch und kann nach den jeweiligen Voraussetzungen der Komponenten und der vorhandenen Prozesseinrichtungen aus dem Fachmann bekannten Verfahren ausgewählt werden. So können die Verbindungen lösbar beispielsweise als Stecker oder nicht lösbar durch beispielsweise Löten oder Schweißen hergestellt werden. Die Leiterplatte wird besonders bevorzugt direkt mit den Signalgebern und -empfängern (insbesondere Sensoren, Ventile, etc.) außerhalb des Gehäuses verbunden.

Der Verbindungsträger kann einstückig oder mehrstückig ausgeführt sein.
Bevorzugt ist der Verbindungsträger erfindungsgemäß ein so genannter Pinkranz, auch als "card edge" bezeichnet , wobei bevorzugt in einem Halterahmen Pressfit-Pins, THT Pins oder Klammer-Pins derart fixiert werden, das sie eine gut entflechtete Verbindung der zentralen Steuereinheit nach oben zur Signal- und Stromverteilungskomponente ermöglichen. So kann dort eine standardisierte Kontaktierung an die oberen Kontaktbereiche der Pressfit-Pins erfolgen.
Der Verbindungsträger kann vorzugsweise aus einem sehr preisgünstigen Material massenhaft gefertigt werden und kann zur mechanischen Stabilisierung des gesamten Gehäusekonzepts beitragen.

Die elektronischen Bauteile der zentralen Steuerungselektronik können bevorzugt in dem wannenförmigen Gehäuseboden vergossen sein.
Diese industriellen Verfahren lassen sich leicht automatisieren und damit auch in bereits bestehende Prozesse eingliedern. Durch den wannenförmigen Aufbau des Gehäusebodens und der darin angeordneten Steuerkeramik ist das Vergießen der elektronischen Bauelemente mit der PCB-Leiterplatte beispielsweise mit Silgel im Vergleich zu den bisher bekannten Aufbauten deutlich vereinfacht, da das Gel bei noch geöffnetem Gehäuse einfach in die Wanne eingefüllt werden kann. Die Anordnung ist leicht zu evakuieren und außerdem kann eine Blasenbildung gut vermieden werden. Damit kann vorliegend im Gegensatz zum Stand der Technik auf thixotropierende Silgele verzichtet werden.

Der wannenförmige Gehäuseboden besteht bevorzugter Weise aus einem Stanzbiegeteil aus einem metallischen Material, besonders bevorzugt ist er aus Aluminium.
In einer Ausgestaltung der Erfindung kann der wannenförmige Gehäuseboden im Randbereich mehrere Stufen aufweisen. So kann beispielsweise eine Vertiefung zur Aufnahme der über die keramische Steuereinheit herausragenden Anteile der Pressfit-Pins ausgebildet sein. Weiterhin kann eine separate Stufe zur Auflage und weiteren mechanischen Fixierung des Verbindungsträgers vorgesehen werden. Schließlich kann eine zusätzliche Stufe zur flächigen Verbindung zwischen dem wannenförmigen Gehäuseboden und der darüber angeordneten Signal- und Stromverteilungskomponente ausgebildet sein.

In einer bevorzugten Ausführungsform der Erfindung wird die keramische Steuerelektronik in die metallische Bodenwanne eingesetzt und mit einem Wärmeleitkleber fest und temperaturoptimiert verklebt. Dies stellt neben einer guten Wärmeableitung eine verlässliche und kostengünstige Fixierung sicher.

Zudem wird auf diese Weise eine Abdichtung des Elektronikraums nach unten beispielsweise zum Getriebeöl hin erreicht.

Besonders bevorzugt können an den Randbereichen des wannenförmigen Gehäusebodens Noppen, oder andere Befestigungselemente ausgeprägt sein, die einen definierten Sitz des Verbindungsträgers sicherstellen.

Zur Herstellung eines erfindungsgemäßen Gehäusekonzepts für ein elektronisches Steuergerät wird eine zentrale Steuerungselektronik mit den elektronischen Bauteilen in einen wannenförmigen Gehäuseboden eingebracht, optional mit einem Vergussmaterial vergossen, mit den Pins des Verbindungsträgers verbunden und eine darüber angeordnete Signal- und Stromverteilungskomponente wird sowohl elektrisch mit den Pins des Verbindungsträgers als auch mechanisch mit dem wannenförmigen Gehäuseboden verbunden.
Der Verbindungsträger kann optional mittels Wärmeleitkleber an der Innenseite des wannenförmigen Gehäusebodens befestigt werden. Bis zur Aushärtung des Klebers ist dadurch vorteilhafterweise ein leichter Höhenausgleich möglich, so dass die Signal- und Stromverteilungskomponente bei der Montage auf die entsprechenden Randbereiche des Verbindungsträgers flächig aufliegt.
Wenn ein größerer Toleranzausgleich erzielt werden soll, kann zwischen der Signal- und Stromverteilungskomponente und dem Verbindungsträger ein Dämpfungselement vorgesehen werden. Zur weiteren mechanischen Stabilisierung der Kontaktstellen zwischen Verbindungsträger und Signal- und Stromverteilungskomponente kann um die Kontaktstellen herum zusätzlich eine Laminierung beispielsweise mit zweiseitigem Acrylklebeband vorgesehen werden.
Nach dem Einsetzen des Verbindungsträgers in den wannenförmigen Gehäuseboden kann die Anordnung optional durch Einfüllen einer Vergussmasse wie zum Beispiel Silgel versiegelt werden. Die mechanische Verbindung zwischen Gehäuseboden, Verbindungsträger und darüber angeordneter Signal- und Stromverteilungskomponenten wird besonders bevorzugt in einem kombinierten Schritt mit der elektrischen Anbindung zwischen den Komponenten hergestellt. Dazu werden die elektrischen Anbindungen mittels Löten und gleichzeitig die mechanische Anbindung mittels Laminieren ausgeführt.
Auf diese Weise ist es vorteilhafterweise möglich, ein mechanisch robustes Gehäusekonzept zu realisieren, das es ermöglicht, den Vergussschritt noch im offenen Zustand auszuführen. Weiterhin vorteilhaft ist aufgrund der Möglichkeit zur Verwendung preisgünstiger Materialien und der Integration von zwei Prozessschritten in einen einzigen eine vereinfachte Montage sicher gestellt. Darüber hinaus kann durch die Verlässlichkeit des Laminierprozesses der sonst übliche Dichtheitstest entfallen.

Bevorzugt wird das erfindungsgemäße Gehäusekonzept für eine integrierte Getriebesteuerung eines Kraftfahrzeugs verwendet.

Die Erfindung wird nachfolgend in beispielhafter Weise anhand von mehreren Ausführungsvarianten in Verbindung mit den Zeichnungen erläutert, ohne darauf beschränkt zu sein.
In diesen zeigt:
**Fig. 1** eine explodierte perspektivische Ansicht auf einen erfindungsgemäßes Gehäusekonzept einer integrierte Steuerungselektronik, und
**Fig. 2** eine Detailansicht des Randbereichs eines erfindungsgemäßen Schaltungsträgers aus Fig. 1.

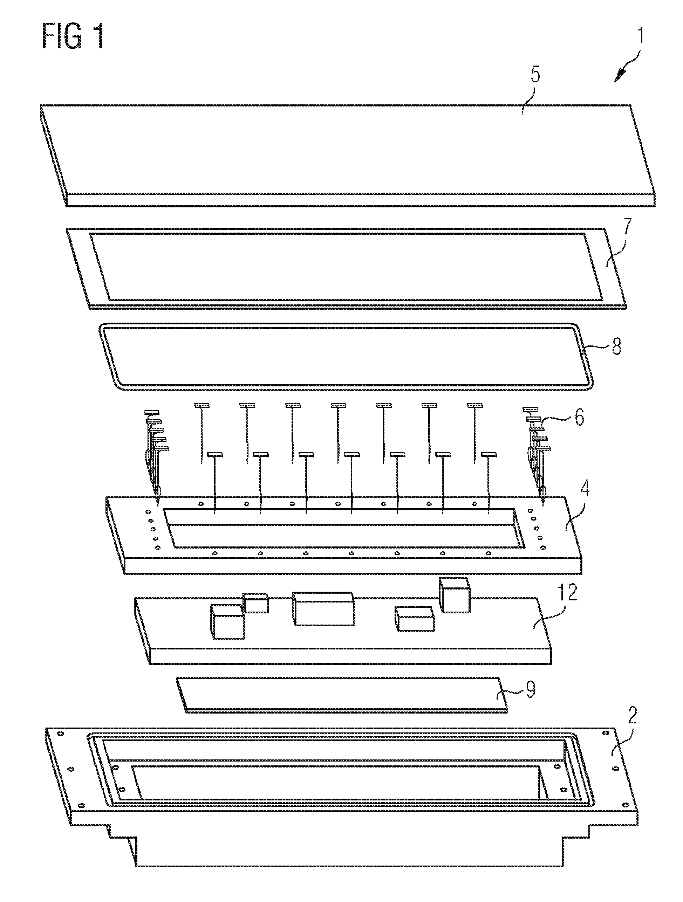

**Fig. 1** zeigt eine explodierte perspektivische Ansicht auf ein erfindungsgemäßes Gehäusekonzept **1** für eine integrierte Steuerungselektronik.
Der wannenförmige Gehäuseboden **2** ist bevorzugt ein Stanzbiegeteil aus Aluminium und nimmt die zentrale Steuerelektronik **12** und den Verbindungsträger **4** vollständig auf. In seinen Randbereichen ist der wannenförmige Gehäuseboden an der darüber angeordneten Signal- und Stromverteilungskomponente **5** befestigt. Die Befestigung kann bevorzugt mittels Laminierung **7** erfolgen. Zusätzlich können auch weitere mechanische Befestigungen wie Nasen, Noppen, Schrauben oder Nieten vorgesehen sein. Der wannenförmige Gehäuseboden **2** fungiert gleichzeitig als Wärmesenke für die darin angeordnete keramische Steuerungselektronik **12,** die daher bevorzugt mittels Wärmeleitkleber **9** an dem Gehäuseboden befestigt ist. Der Verbindungsträger **4** weist in definierter Abfolge Aufnahmen für stiftförmige Verbindungen beispielsweise in Form von Pressfit-Pins **6,** THT-Pins oder klammerartigen Pins auf. Zwischen der Oberseite des Verbindungsträgers **4** und der darüber angeordneten Signal- und Stromverteilungskomponente **5** kann ein Dämpfungselement vorgesehen sein. Gleichermaßen kann in diesem Bereich alternativ oder zusätzlich ein Dichtring **8** oder eine andere Form einer Dichtung vorgesehen werden. Die Signal- und Stromverteilungskomponente **5** kann bevorzugt mittels Epoxy- oder Acrylkleberfolie am Gehäuseboden **2** befestigt sein. Bevorzugt besteht sie aus einer zweilagigen starren Leiterplatte mit einem elektrisch isolierenden Kern und einer Kupferbschichtung. Sie kann auch mehrlagig ausgeführt sein mit mehreren leitenden Schichten zur besseren Entkopplung der Signal- und Strompfade. Gleichermaßen kann sie biegbar ausgestaltet sein, so dass eine Anpassung an die geometrischen Vorgaben in komplexen Bauräumen möglich ist.

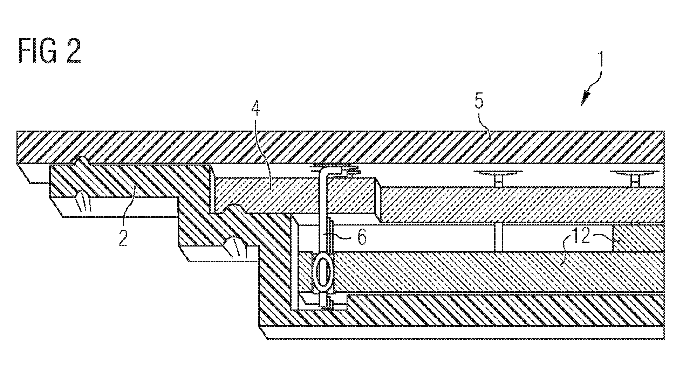

**Fig. 2** zeigt in einer Detailansicht den Randbereich eines erfindungsgemäßen Gehäusekonzepts **1** aus **Fig. 1****.** Die Signal- und Stromverteilungskomponente **5** weist Lötkontaktbereiche zur Anbindung der Pins **6** des Verbindungsträgers **4** auf. Der Verbindungsträger **4** weist definierte Aufnahmen bestückt mit Pressfit-Pins **6** auf und kann in seinen Randbereichen beispielsweise mittels Dichtungskleber in Form einer Epoxy- oder Acrylkleberfolie durch Laminierung auf einer Stufe des Gehäusebodens **2** befestigt werden. Der wannenförmige Gehäuseboden **2** ist bevorzugt als Stanzbiegeteil aus Aluminium gefertigt und nimmt den Verbindungsträger **4** und die elektronische Steuereinheit **12** vollständig auf. Er weist an seinem Kanten einen flächigen Bereich zur Laminierung auf die Signal- und Stromverteilungskomponente **5** mit Dichtungskleber in Form einer Epoxy- oder Acrylkleberfolie auf. Gleichermaßen kann ein flüssiger Kleber in Form einer Raupe aufgebracht werden. Gleichzeitig ist zudem ein Vorsprung zum Einrasten von korrespondierenden Nasen des Gehäusebodens **2** in eine entsprechende Vertiefung der Signal- und Stromverteilungskomponenten vorgesehen, so dass eine weitere mechanische Stabilisierung erreicht wird.

Zusammenfassend wird demnach ein Gehäusekonzept für eine integrierte Steuerungselektronik vorgeschlagen, bei dem der Gehäuseboden wannenförmig ausgestaltet ist, darin die zentrale Steuerungselektronik mit den elektronischen Bauteilen derart angeordnet ist, dass die elektrische Verbindung durch Kontaktstifte in einem Verbindungsträger mit der darüber angeordneten Signal- und Stromverteilungskomponente hergestellt werden kann, und bei dem der Gehäuseboden umlaufend mit der Signal- und Stromverteilungskomponente verbunden ist.
Durch diesen Aufbau entfällt vorteilhafterweise die Notwendigkeit für eine separate Verdeckelung des Gehäuses. Die Signal- und Potentialverteilung kann von relativ preiswerten PCB-Leiterplatten und Kontaktstiften übernommen werden, so dass ein Einsatz von vergleichsweise teuren flexiblen Leiterplatten entfallen kann.
Der Montageprozess kann durch die Laminierung und Verlötung der Schaltungsträger mit der darüber angeordneten Signal- und Stromverteilungskomponente in einem Schritt deutlich verkürzt werden.
Die Montage ist zudem leicht und kostengünstig in den Gesamtmontageprozess einer elektronischen Vorrichtung integrierbar.

## Patentansprüche

1. Gehäusekonzept (1) für eine integrierte Steuerungselektronik mit einem Gehäuseboden (2), einer zentralen Steuerungselektronik (12) mit elektronischen Bauteilen, einem Verbindungsträger (4) und einer Signal- und Stromverteilungskomponente (5) als elektrischer Verbindung zwischen der zentrale Steuerungselektronik (12) und peripheren Komponenten, **dadurch gekennzeichnet, dass** der Gehäuseboden (2) wannenförmig ausgestaltet ist, darin der Verbindungsträger (4) mit Kontaktstiften (6) und die zentralen Steuerungselektronik (12) derart angeordnet sind, dass die Steuerungselektronik (12) durch die Kontaktstifte (6) elektrisch mit der darüber angeordneten Signal- und Stromverteilungskomponente (5) verbunden werden kann, und dass der Gehäuseboden (2) umlaufend mit der Signal- und Stromverteilungskomponente (5) verbunden ist.

2. Gehäusekonzept (1) nach Anspruch 1, **dadurch gekennzeichnet, dass** die Signal- und Stromverteilungskomponente (5) zwei- oder mehrlagig ist.

3. Gehäusekonzept (1) nach Anspruch 2, **dadurch gekennzeichnet, dass** die mehrlagige Signal- und Stromverteilungskomponente (5) ihrerseits verschiedene Kontaktstellen zur elektronischen Anbindung der peripheren Komponenten aufweist.

4. Gehäusekonzept (1) nach Anspruch 2 oder 3, **dadurch gekennzeichnet, dass** die Signal- und Stromverteilungskomponente (5) einstückig oder mehrstückig ausgeführt ist.

5. Gehäusekonzept (1) nach einem der vorhergehenden Ansprüche, **dadurch gekennzeichnet, dass** die Kontaktstifte (6) in definierten Aufnahmen des Verbindungsträgers angeordnet sind.

6. Gehäusekonzept (1) nach einem der vorhergehenden Ansprüche, **dadurch gekennzeichnet, dass** die elektronischen Bauteile (12) der zentralen Steuerungselektronik in dem wannenförmigen Gehäuseboden (2) vergossen sind.

7. Verwendung eines Gehäusekonzepts (1) nach einem der vorhergehenden Ansprüche 1 bis 6 bevorzugt für eine integrierte Getriebesteuerung eines Kraftfahrzeugs.
